# EUROPÄISCHE PATENTANMELDUNG

(11) **EP 4 831 657 A1**
(43) Veröffentlichungstag der Anmeldung: **28.10.2026**
(21) Anmeldenummer: 26173789.4
(22) Anmeldetag: 21.04.2026
(51) Int. Cl.: G01R 31/12, G01R 31/16, G01R 31/34

(54) **PRÜFVORRICHTUNG UND PRÜFVERFAHREN ZUR DETEKTION VON ISOLATIONSFEHLERN**

(30) Priorität: 25.04.2025 DE 102025115923
(71) Anmelder: Gdg Gerätebau Gesellschaft Mit Beschränkter Haftung, 77880 Sasbach (DE)
(72) Erfinder: Bohnert, Markus, 77880 Sasbach (DE)
(74) Vertreter: Werner, André

(57) **Zusammenfassung**

Die Erfindung betrifft eine Prüfvorrichtung und ein Prüfverfahren zur Detektion von Isolationsfehlern an elektrischen, elektroisolierten Komponenten (1) in elektrischen Maschinen. Die Prüfvorrichtung umfasst eine Prüfkammer (3) mit definierter Prüfkammeratmosphäre, mindestens eine berührungslos zur zu prüfenden elektrischen, elektroisolierten Komponente (1) angeordnete Feldelektrode (2), eine Hochspannungseinheit (4) zur Erzeugung von gepulster Gleichspannung, eine Steuerungs- und Prüfeinheit (5) zur Erkennung von Lichtbogenereignissen anhand von Soll-/Istspannungsverlaufsvergleichen sowie mindestens eine Kameraeinheit (6) zur visuellen Lokalisierung der Lichtbogenereignisse. Die Prüfvorrichtung und das Prüfverfahren ermöglichen eine empfindliche, reproduzierbare und zerstörungsfreie Prüfung insbesondere von Wicklungen, Nutisolationen oder Hairpin-Leitern in Serienfertigungsprozessen.

## Beschreibung

Die Erfindung betrifft das technische Gebiet der Qualitätssicherung und Fehlerdiagnose in der Herstellung elektrischer Maschinen. Insbesondere betrifft sie eine Prüfvorrichtung sowie ein zugehöriges Prüfverfahren zur Detektion von Isolationsfehlern an elektrischen, elektroisolierten Komponenten, wie beispielsweise Wicklungen, isolierten Leiterstrukturen oder Nutisolierungen von Spulenkernen, die Bestandteil eines Wicklungssystems einer elektrischen Maschine sind. Die Erfindung ist insbesondere für den Einsatz in Produktions- und Prüfumgebungen geeignet, in denen die elektrische Isolation solcher Komponenten auf ihre Integrität überprüft werden muss, bevor sie in den weiteren Fertigungs- oder Montageprozess überführt werden. Primäre Einsatzgebiete der Prüfvorrichtung und des Prüfverfahrens sind die Prüfung von Wicklungsdrähten von Spulen, wobei die äußere Wicklungslage bzw. das äußere Layer mit einbezogen wird, sowie von Spulenkernen, speziell an der Nutisolation und Hairpins.

Die elektrische Isolation von Wicklungssystemen in elektrischen Maschinen ist von zentraler Bedeutung für deren Funktionssicherheit und Lebensdauer. Insbesondere bei Maschinen mit Wicklungssystemen, wie etwa Elektromotoren oder Generatoren, müssen die verwendeten Isolierstoffe eine hohe elektrische Durchschlagsfestigkeit aufweisen, um Kurzschlüsse, Teilentladungen und Folgeschäden zu vermeiden. Bereits geringe mechanische Beschädigungen, Fertigungstoleranzen oder Materialfehler können die Isolationswirkung beeinträchtigen und zu latenten Defekten führen, die im späteren Betrieb kritisch werden.

Zur Detektion solcher Isolationsfehler sind verschiedene Prüfverfahren bekannt. In der Praxis werden häufig Hochspannungsprüfungen angewendet, bei denen eine Prüfspannung zwischen einem elektrischen Leiter und einem leitenden Gehäuseteil oder einem Massepotenzial angelegt wird. Ziel dieser Verfahren ist es, einen Durchschlag herbeizuführen, sofern ein Isolationsdefekt vorliegt, um den Fehler gezielt aufzudecken.

Bei der Herstellung von elektrischen Kleinmaschinen, insbesondere Statoren und Rotoren mit gewickelten Leiterstrukturen, ist die Überprüfung der elektrischen Isolation ein etabliertes und verpflichtendes Prüfverfahren. Die gängigen Prüfmethoden basieren dabei auf dem Anlegen eines Hochspannungsimpulses oder einer definierten Spannungsform an die Wicklung. Im Falle einer vorhandenen Isolationsbeschädigung kommt es zu einem Durchschlag, Teilentladung und/oder einer Veränderung im Spannungsverlauf, was als Fehler detektiert wird. Voraussetzung für die Erkennbarkeit eines solchen Fehlers ist jedoch das Vorhandensein eines elektrisch wirksamen Gegenpotenzials in unmittelbarer Nähe zur beschädigten Stelle, wie es typischerweise bei Windungsschlüssen der Fall ist.

US 6 064 172 A beschreibt ein Verfahren zur berührungslosen Prüfung elektrischer Isolation, bei dem ein Lichtbogen durch ein elektrisches Feld ausgelöst wird, sofern ein Isolationsfehler vorliegt. Die Detektion des Lichtbogens erfolgt optisch mittels eines Fotodetektors, der die Lichtemission des Entladevorgangs erfasst.

Problematisch ist es, mit der bekannten Prüftechnik Isolationsfehler zuverlässig zu erkennen, bei denen kein elektrischer Gegenpol vorhanden ist oder bei denen die Schlagweite zu groß ist, um eine Entladung zwischen zwei beschädigten Punkten zu ermöglichen. In diesen Fällen bleibt die Beschädigung mit konventionellen Verfahren vielfach unentdeckt. Dies betrifft insbesondere isolierte Einzelstellen auf einem Draht oder in einer Nut, bei denen keine zweite geschädigte Windung oder kein nahe gelegenes Gegenpotential vorhanden ist. Das macht die Fehlererkennung mit klassischen Verfahren unzuverlässig oder gar unmöglich.

Die Aufgabe der Erfindung besteht darin, die bestehenden Einschränkungen bei der Detektion von Isolationsfehlern an elektrischen, elektroisolierten Komponenten elektrischer Maschinen zu überwinden. Insbesondere soll eine Möglichkeit geschaffen werden, auch solche Isolationsschäden zuverlässig zu erkennen, bei denen kein elektrisch leitfähiges Gegenpotential in unmittelbarer Nähe der beschädigten Stelle vorhanden ist oder bei denen die elektrische Schlagweite die Entladung verhindert.

Zudem besteht die Aufgabe darin, die Reproduzierbarkeit, Empfindlichkeit und Ortsauflösung der Fehlerdetektion zu verbessern, insbesondere bei komplexen Wicklungsstrukturen oder schwer zugänglichen Isolationszonen wie in Nuten oder an Einzeladern. Die Erfindung soll weiterhin ermöglichen, kleinräumige und verdeckte Isolationsdefekte - dazu zählen auch defekte Wicklungsdrähte, die unter einem Layer von Drahtwicklungen liegen - zu identifizieren, die mit herkömmlichen Prüfmethoden entweder nicht erkannt oder fälschlich als unkritisch eingestuft würden.

Ein weiteres Ziel ist es, ein Prüfverfahren und eine zugehörige Prüfvorrichtung bereitzustellen, die sich für den Einsatz in der Serienfertigung eignen und dabei auch in frühen Fertigungsphasen - beispielsweise im Rahmen von Nullserien oder im Neuproduktanlauf - eine zuverlässige und ortsgenaue Fehlererkennung ermöglichen, ohne dass aufwendige, manuelle oder visuell interpretierte Auswertungen erforderlich sind.

Diese Aufgabe wird durch eine Prüfvorrichtung nach Anspruch 1 sowie ein Prüfverfahren nach Anspruch 6 gelöst. Zweckmäßige Weiterbildungen der Erfindung sind in den Ansprüchen 2 bis 5 sowie 7 bis 10 aufgeführt.

Nach Maßgabe der Erfindung dient die Prüfvorrichtung zur Detektion von Isolationsfehlern an einer elektrischen, elektroisolierten Komponente, die Bestandteil einer ein Wicklungssystem beinhaltenden Baugruppe einer elektrischen Maschine ist. Hierbei weist die zu prüfende elektrische, elektroisolierte Komponente eine Isolationsschicht auf, welche eine elektrisch leitfähige Basisstruktur umgibt.

Unter der elektrischen, elektroisolierten Komponente wird im Rahmen der Erfindung ein Bauteil verstanden, das Bestandteil einer elektrischen Maschine ist und die elektrisch leitfähige Basisstruktur mit einer darauf oder darum angeordneten elektrisch wirksamen Isolationsschicht kombiniert. Die Isolationsschicht dient dazu, das elektrisch leitfähige Bauteil gegenüber seiner Umgebung elektrisch zu trennen und insbesondere das Entstehen ungewollter Strompfade, Lichtbögen oder Durchschläge zu verhindern. Eine solche elektrische, elektroisolierte Komponente kann beispielsweise ein isolierter Draht, ein Hairpin-Leiter, eine Wicklung in einer Statornut mit Nutisolation oder eine andere elektrisch leitfähige Struktur sein, die zum Schutz gegen Kurzschluss oder Überschlag partiell oder vollständig isoliert ausgeführt ist. Charakteristisch ist, dass sowohl die leitfähige Basisstruktur als auch die Isolation in einer festen geometrischen Beziehung zueinander stehen und gemeinsam eine zu prüfende Funktionseinheit bilden. Die Isolationsschicht stellt dabei eine funktionskritische Komponente dar, deren Defekte potenziell zu sicherheits- oder funktionsrelevanten Störungen führen können.

Die vorgeschlagene Prüfvorrichtung und das entsprechende Prüfverfahren basieren auf einer Detektion von Isolationsfehlern durch Erfassung elektrischer Messgrößen bei gleichzeitiger visueller Überwachung.

Die erfindungsgemäße Prüfvorrichtung umfasst eine Prüfkammer, die zur Aufnahme der zu prüfenden elektrischen, elektroisolierten Komponente bzw. der Baugruppe, die die zu prüfende elektrische, elektroisolierte Komponente beinhaltet, dient. Die Prüfkammer ist atmosphärisch abgedichtet und enthält eine definierte Prüfkammeratmosphäre.

Weiterhin umfasst die Prüfvorrichtung mindestens eine Hochspannungseinheit, die zur Erzeugung einer Prüfspannung vorgesehen ist. Die Hochspannungseinheit ist zum Beispiel eine außerhalb der Prüfkammer befindliche Induktionsspule. Die Prüfspannung ist eine gepulste Gleichspannung mit einer Amplitude im Bereich von 400 V bis 3000 V, insbesondere im Bereich von 900 V bis 1500 V. Mittels der Hochspannungseinheit werden (Prüf-)Spannungspulse erzeugt, die jeweils einen definierten Sollspannungsverlauf (auch Referenzspannungsverlauf) aufweisen. Der mittels der Hochspannungseinheit erzeugte, vorgegebene Spannungspuls wird auch als Referenzpuls und dessen Sollspannungsverlauf als Referenzpulsverlauf bezeichnet.

Des Weiteren ist mindestens eine Feldelektrode Bestandteil der Prüfvorrichtung. Diese ist im Inneren der Prüfkammer berührungslos zur zu prüfenden elektrischen, elektroisolierten Komponente angeordnet. Die elektrisch leitfähige Basisstruktur der Komponente sowie die Feldelektrode sind mit der Hochspannungseinheit derart verbunden, dass die Prüfspannung zwischen der Basisstruktur und der Feldelektrode anliegt. Vorzugsweise umfasst die Prüfvorrichtung mehrere der Feldelektroden.

Zudem ist eine Steuerungs- und Prüfeinheit in der Prüfvorrichtung integriert. Diese ist eingerichtet, das Anlegen der Prüfspannung zu steuern, den Istspannungsverlauf der Prüfspannung während der Spannungspulse, d. h. den tatsächlichen Pulsverlauf während der Messung, zu erfassen und anhand von Abweichungen zwischen dem Istspannungsverlauf und dem Sollspannungsverlauf auftretende Lichtbogenereignisse zu erkennen und zu signalisieren. Der Spannungsverlauf kann zum Beispiel als Kurve der momentan gemessenen Prüfspannung über der Zeit erfasst werden. Die Form dieser Kurve wird auch als Pulsform bezeichnet. Abweichungen der Pulsform des Istspannungsverlaufs vom Sollspannungsverlauf können charakteristische Indikatoren für das Auftreten eines Lichtbogenereignisses sein. Der Spannungsverlauf kann alternativ auch als integraler Wert, d. h. als Spannungsintegral (∫Udt), erfasst und ausgewertet werden. Ganz allgemein wird also der tatsächlich auftretende, gemessene Spannungspuls der Prüfspannung mit dem Referenzpuls verglichen, wobei auftretende Abweichungen zur Indikation von Lichtbogenereignissen herangezogen werden.

Zusätzlich umfasst die Prüfvorrichtung mindestens eine Kameraeinheit, die zur visuellen Lokalisierung der Lichtbogenereignisse dient. Die Kameraeinheit ist mit der Steuerungs- und Prüfeinheit verbunden, um erfasste Bilddaten mit den elektrisch erfassten Signalen, insbesondere der erfassten Prüfspannung, zu synchronisieren.

Das erfindungsgemäße Prüfverfahren zur Detektion von Isolationsfehlern an der elektrischen, elektroisolierten Komponente wird mittels der erfindungsgemäßen Prüfvorrichtung durchgeführt; es beinhaltet die nachfolgend beschriebenen Schritte.

Zunächst erfolgt das Einbringen der zu prüfenden elektrischen, elektroisolierten Komponente bzw. der Baugruppe, die die zu prüfende elektrische, elektroisolierte Komponente beinhaltet, in die Prüfkammer. Anschließend wird die mindestens eine Feldelektrode in vorgegebenem Abstand zur zu prüfenden elektrischen, elektroisolierten Komponente positioniert. Vorzugsweise liegt der Abstand zwischen der Feldelektrode und der elektrischen, elektroisolierten Komponente, d. h. der mit der Isolationsschicht versehenen Oberfläche, im Bereich von 5 mm bis 30 mm.

Daraufhin wird eine definierte Prüfkammeratmosphäre in der Prüfkammer eingestellt. Die Prüfkammeratmosphäre wird insbesondere so eingestellt, dass die mittlere freie Weglänge der Elektronen in der Prüfkammeratmosphäre gegenüber normalen atmosphärischen Bedingungen stark erhöht wird und/oder die Prüfkammeratmosphäre eine Zusammensetzung mit leichter Ionisierbarkeit aufweist. Dies kann zum Beispiel durch gezielte Evakuierung der Prüfkammer oder durch Einbringen eines Prozessgases, zum Beispiel eines Edelgases wie Helium, Neon und/oder Argon, realisiert werden.

Im Anschluss daran erfolgt das Anlegen der Prüfspannung zwischen der elektrisch leitfähigen Basisstruktur der zu prüfenden elektrischen, elektroisolierten Komponente und der Feldelektrode in Form des Spannungspulses mit dem definierten zeitlichen Sollspannungsverlauf. Der Spannungspuls weist eine Amplitude im Bereich von 400 V bis 3000 V, insbesondere im Bereich von 900 V bis 1500 V, und eine Pulsdauer im Bereich von 3 µs bis 15 µs, insbesondere im Bereich von 5 µs bis 10 µs, auf.

Während des Spannungspulses wird der zeitliche Istspannungsverlauf der Prüfspannung, d. h. der gemessene Pulsverlauf, erfasst. Anschließend erfolgt das Vergleichen des Sollspannungsverlaufs bzw. Referenzpulsverlauf und des Istspannungsverlaufs bzw. gemessenen Pulsverlaufs der Prüfspannung, wobei ein Lichtbogenereignis anhand von Abweichungen des Istspannungsverlaufs vom Sollspannungsverlauf erkannt und bei Erkennung eines Lichtbogenereignisses ein Signal ausgelöst wird. Das Erfassen und Auswerten des Spannungsverlaufs kann sowohl anhand des zeitlichen Kurvenverlaufs, d. h. der Pulsform, oder anhand von integralen Werten, insbesondere dem Spannungsintegral, erfolgen. Die Auswertung des Istspannungsverlaufs kann zum Beispiel durch eine rechnerische Differenzbildung zwischen den momentan gemessenen Istspannungswerten und den zugehörigen Sollspannungswerten des Sollspannungsverlaufs erfolgen, bei der der tatsächliche Istspannungsverlauf mit dem vorgegebenen Sollverlauf verglichen wird.

Parallel zur Erfassung der Prüfspannung erfolgt das Aufzeichnen von einem oder mehreren Bildern der zu prüfenden elektrischen, elektroisolierten Komponente während des Spannungspulses mittels der Kameraeinheit zur Erfassung und Lokalisierung des Lichtbogenereignisses. Das Auslösen der Kameraeinheit zur Bilderfassung ist vorzugsweise mit der Spannungserfassung synchronisiert. Insbesondere wird die Kameraeinheit zur Bilderfassung getriggert ausgelöst, wobei als Trigger-Signal das Signal dient, das bei Erkennung eines Lichtbogenereignisses anhand des Soll-/Istspannungsverlauf-Vergleichs ausgelöst wird.

Die erfindungsgemäße Prüfvorrichtung und das darauf basierende Prüfverfahren zur Detektion von Isolationsfehlern an elektrischen, elektroisolierten Komponenten zeichnen sich durch eine Reihe von Vorteilen gegenüber bekannten Prüfvorrichtungen und -verfahren aus.

Die atmosphärisch abgedichtete Prüfkammer mit definierter Prüfkammeratmosphäre ermöglicht es, die Prüfbedingungen kontrolliert zu gestalten und so die Reproduzierbarkeit der Prüfprozesse wesentlich zu verbessern. Insbesondere erlaubt diese die gezielte Einstellung von Parametern wie Druck oder Gaszusammensetzung, sodass sich - auch unter Nutzung des Paschen-Gesetzes - die Entladungsempfindlichkeit erhöhen und die Prüfgüte insbesondere bei kleinsten oder schwer lokalisierbaren Isolationsfehlern verbessern lässt.

Durch die Nutzung (vorzugsweise skalierter) gepulster Gleichspannung mit definiertem zeitlichem Sollspannungsverlauf wird die Isolationsschicht gezielt und kurzzeitig belastet, gerade so lange, dass ein kurzzeitiger Lichtbogen (von wenigen Mikrosekunden) entsteht und eine Beschädigung der elektrischen, elektroisolierten Komponenten auf ein Minimum reduziert wird. Der Einsatz solcher Spannungspulse ermöglicht eine präzise elektrische Anregung und eine sehr schnelle Reaktion der Steuerungs- und Prüfeinheit bei Auftreten eines Lichtbogenereignisses. Gleichzeitig lassen sich die Prüfbedingungen exakt wiederholen, was die Vergleichbarkeit von Prüfergebnissen erhöht - ein entscheidender Vorteil in der Serienfertigung und Qualitätssicherung.

Ein weiterer technischer Vorteil ergibt sich aus der berührungslosen Anordnung der Feldelektrode. Diese ermöglicht es, auch isolierte Einzelstellen - wie Lackschäden auf Drahtleitungen oder beschädigte Nutisolationen - gezielt in ein elektrisches Feld einzubetten, selbst wenn kein leitfähiges Gegenelement direkt gegenüberliegt. Dadurch können auch solche Fehler aufgespürt werden, bei denen die Schlagweite zu groß ist, um mit konventionellen Prüfverfahren einen Durchschlag zu erzeugen. Das Prüfverfahren wird mit der dementsprechend eingerichteten Prüfvorrichtung so ausgeführt, dass die Schlagweiten vorzugsweise im Bereich von 1 cm bis 4 cm liegen.

Die ebenfalls beanspruchte Steuerungs- und Prüfeinheit, welche die Prüfspannung steuert und den Istspannungsverlauf während des Spannungspulses erfasst, ermöglicht eine automatisierte und sensitive Fehlerdetektion. Durch den direkten Vergleich von Ist- und Sollspannungsverlauf können bereits geringfügige Abweichungen erkannt werden, die typisch für Lichtbogenbildung oder Teilentladungen sind. Dies erhöht die Empfindlichkeit und Reaktionsgeschwindigkeit des Prüfvorgangs und vermeidet subjektive Interpretationen.

Besonders vorteilhaft ist die zweigleisige Auswertung, bestehend aus dem elektrischen Vergleich von Ist- und Sollspannungsverlauf mittels der Steuerungs- und Prüfeinheit und der visuellen Lokalisierung des Lichtbogenereignisses mittels der Kameraeinheit. Diese Kombination ermöglicht eine sichere Unterscheidung zwischen echten Isolationsfehlern und ungefährlichen Überschlägen oder Störungen, da die Fehler nicht nur erkannt, sondern auch lokalisiert und dokumentiert werden können. Dies wiederum erlaubt eine präzise Rückverfolgung, vereinfacht die statistische Prozessüberwachung und eröffnet die Möglichkeit zu einer gezielten Nachbesserung.

Das erfindungsgemäße Prüfverfahren und die zugehörige Prüfvorrichtung sind für eine Vielzahl von Anwendungen in der Fertigung und Qualitätssicherung elektrischer Maschinen einsetzbar, insbesondere dort, wo gewickelte oder elektrisch isolierte Leiterstrukturen zuverlässig auf Isolationsfehler geprüft werden müssen. Ein zentrales Einsatzgebiet ist die Prüfung von Statoren und Rotoren elektrischer Kleinmaschinen, insbesondere im Automobilbereich sowie in der Industrieantriebstechnik, wo hohe Stückzahlen und hohe Qualitätsanforderungen zusammentreffen.

Ein wesentliches Anwendungsfeld liegt in der Prüfung von Hairpin-Wicklungen, wie sie zunehmend in elektrischen Traktionsmotoren eingesetzt werden. Hierbei werden flache, vorgeformte Kupferleiter mit Isolationsschicht in Statornuten eingesetzt und dort elektrisch kontaktiert. Die Erfindung eignet sich zur Früherkennung von Lackschäden, Isolationsdurchbrüchen sowie unvollständiger oder spröder Isolation an den Hairpin-Enden oder an Stellen, die durch Biegen oder mechanische Beanspruchung potenziell beschädigt wurden.

Darüber hinaus ist das Verfahren einsetzbar bei der Prüfung von klassischen Runddrahtwicklungen, wie sie in Spulen oder anderen konventionellen Wicklungsgeometrien verwendet werden. Auch hier können isolierte Einzeldrähte durch das elektrische Feld der Prüfvorrichtung gezielt belastet werden, um Lackschäden oder andere Isolationsdefekte aufzudecken.

Ein weiterer wesentlicher Anwendungsfall ist die Prüfung von Nutisolierungen innerhalb eines Statorblechpakets. Diese Nutisolierungen, häufig in Form von folienartigen oder beschichteten Isolationsmaterialien, dienen als schützende Trennschicht zwischen den Wicklungen und dem leitenden Eisenkern. Beschädigungen, Einschlüsse oder Fehlstellen in der Nutisolation können zu latenten Isolationsfehlern führen, die durch das erfindungsgemäße Verfahren sicher erkannt werden können - auch dann, wenn noch keine Wicklung eingesetzt ist und die Prüfung bereits am nackten Stator erfolgen soll.

Die Erfindung eignet sich ferner zur Prüfung von gewickelten Spulensegmenten oder Einzelzahnsegmenten, wie sie in modular aufgebauten Maschinen oder bei der Segmentfertigung zum Einsatz kommen. Auch Teilwicklungen, die vor dem Verguss oder dem Endmontageschritt getestet werden sollen, können mit dem Verfahren geprüft werden.

Ein weiteres Einsatzfeld liegt in der Nullserienprüfung oder in der Qualifikation neuer Wicklungskonzepte, etwa im Rahmen von Entwicklungsprojekten oder bei Fertigungsumstellungen. Hier ermöglicht das Verfahren eine frühe, zerstörungsfreie Diagnose von Isolationsproblemen, bevor es zu teuren Montagefehlern oder Feldrückläufern kommt.

Nicht zuletzt eignet sich das Verfahren auch zur Prüfung von Bauteilen mit Sonderisolierungen, etwa lackierten Stromschienen, isolierten Anschlussleitungen oder komplexen Verbindungselementen, bei denen herkömmliche Kontaktierungs- oder Prüfmethoden technisch nicht praktikabel sind.

Zusammenfassend bieten die erfindungsgemäße Prüfvorrichtung und das erfindungsgemäße Verfahren vielseitige Einsatzmöglichkeiten in der Prüfung von isolierten Wicklungsstrukturen aller Art - von Einzeldrähten über Hairpin-Leiter bis hin zu Nutisolierungen und kompletten Wicklungssystemen - sowohl im fertig montierten Zustand als auch in Zwischenstufen der Fertigung. Die Erfindung adressiert damit gezielt industrielle Anforderungen in den Bereichen Automotive, Elektromaschinenbau, Spulenfertigung und Hochvoltantriebstechnik.

Gemäß einer bevorzugten Ausgestaltung der Erfindung umfasst die Prüfvorrichtung eine an die Prüfkammer angeschlossene Unterdruckerzeugungseinheit, die zur gezielten Evakuierung der Prüfkammer eingerichtet ist. Die Prüfkammer ist dabei als atmosphärisch abgedichtete Unterdruckkammer beziehungsweise Vakuumkammer ausgeführt, wodurch es möglich ist, die Prüfkammeratmosphäre gezielt einzustellen und unabhängig von Umgebungsbedingungen zu kontrollieren. Die Evakuierung dient insbesondere dazu, den Druck innerhalb der Prüfkammer auf einen definierten Druckwert zu senken, bevorzugt auf einen Druckwert zwischen 1 mbar und 10 mbar. Diese Druckeinstellung verbessert die Zündbedingungen für Lichtbogenentladungen, da durch die reduzierte Teilchendichte die mittlere freie Weglänge der Elektronen vergrößert wird, wodurch diese vor einer Kollision mit einem Gasteilchen eine höhere kinetische Energie aufbauen können. In Verbindung mit der Ionisierbarkeit der Prüfkammeratmosphäre lässt sich dadurch die Wahrscheinlichkeit einer kontrollierten Gasentladung an einer fehlerhaften Isolationsstelle gezielt erhöhen. Darüber hinaus kann durch die Evakuierung eine definierte Ausgangsbedingung geschaffen werden, zum Beispiel auch, um gezielt Prozessgase einzuleiten, welche die Lichtbogenbildung weiter unterstützen.

Gemäß einer weiteren vorteilhaften Ausgestaltung umfasst die Prüfvorrichtung ein an die Prüfkammer angeschlossenes Prozessgasmodul, das zur Einleitung eines Prozessgases in die Prüfkammer vorgesehen ist. Das Prozessgas bildet nach der Evakuierung die definierte Prüfkammeratmosphäre, in der die Prüfung der elektrischen, elektroisolierten Komponente erfolgt. Durch die gezielte Wahl und Dosierung des Prozessgases kann die Zusammensetzung der Prüfkammeratmosphäre so eingestellt werden, dass die Bedingungen für die Erzeugung eines Lichtbogens im Fehlerfall optimiert werden. Dies betrifft insbesondere die Ionisierbarkeit des Prozessgases sowie dessen Einfluss auf die Zündspannung unter Nutzung des Paschen-Gesetzes. Geeignete Prozessgase sind zum Beispiel Edelgase wie Argon, Neon oder Helium, wobei sich Argon aufgrund seiner vergleichsweise geringen Ionisierungsenergie insbesondere eignet, da es bereits bei moderaten Feldstärken zuverlässig zündfähige Entladungen ermöglicht. Die Prüfkammeratmosphäre kann gemäß einer Ausgestaltung überwiegend aus einem Edelgas bestehen. Nutzbar sind aber auch andere Gase als Prozessgas, wie zum Beispiel Luft oder Stickstoff.

Das Prozessgasmodul kann so ausgestaltet sein, dass es das jeweilige Prozessgas nach Erreichen eines definierten Unterdrucks automatisch oder gesteuert in die Prüfkammer einleitet. Hierdurch lässt sich nicht nur die Prüfempfindlichkeit verbessern, sondern auch die Reproduzierbarkeit der Prüfbedingungen steigern, da Schwankungen durch unkontrollierte Umgebungseinflüsse ausgeschlossen werden. Zusätzlich erlaubt die kontrolliert einstellbare Prüfkammeratmosphäre die gezielte Beeinflussung der mittleren freien Weglänge von Elektronen, was sich unmittelbar auf die Effektivität der Feldanregung und Lichtbogenzündung auswirkt. Das Prozessgasmodul bildet in diesem Zusammenhang eine funktionale Ergänzung zur Unterdruckerzeugungseinheit.

Gemäß einer Ausgestaltung des Prüfverfahrens kann vorgesehen sein, dass vor dem Anlegen der Prüfspannung ein elektrischer Vorpuls angelegt wird, um eine Vorionisierung der Prüfkammeratmosphäre zu erzeugen. Der elektrische Vorpuls wird dabei zeitlich vor dem eigentlichen Spannungspuls mit definierter Amplitude und Pulsdauer angelegt. Der Zweck des Vorpulses besteht darin, die Prüfkammeratmosphäre gezielt elektrisch vorzubereiten, indem freie Ladungsträger, insbesondere Elektronen, erzeugt werden, die anschließend die Zündwahrscheinlichkeit eines Lichtbogens beim Spannungspuls erhöhen. Dies trägt wesentlich zur Reproduzierbarkeit und Empfindlichkeit des Prüfverfahrens bei, da eine bereits teilweise ionisierte Atmosphäre eine schnellere und kontrolliertere Entladung bei Vorliegen eines Isolationsfehlers ermöglicht.

Der Vorpuls ist vorzugsweise als ein kurzer, niederenergetischer Spannungspuls ausgeführt, dessen Amplitude unterhalb der typischen Durchschlagspannung liegt, jedoch ausreicht, um eine erste Ionisation von Gasmolekülen zu bewirken. Dadurch kommt es noch nicht zu einem vollständigen Lichtbogendurchschlag, sondern zu einer definierten Vorkonditionierung der Gasmoleküle im Prüfraum. Diese Vorionisierung bewirkt eine Reduktion der erforderlichen Zündspannung beim anschließenden Hauptpuls, insbesondere bei Prüfungen im Bereich niedriger Drücke (1 mbar bis 10 mbar).

Gemäß einer weiteren vorteilhaften Ausgestaltung umfasst die Prüfvorrichtung eine in der Prüfkammer angeordnete UV-Lichtquelle zur Vorionisierung der Prüfatmosphäre. Die UV-Lichtquelle ist dabei so positioniert und ausgerichtet, dass sie gezielt die Bereiche der Prüfkammer bestrahlt, in denen sich die zu prüfende elektrische, elektroisolierte Komponente sowie die Feldelektrode befinden. Die UV-Lichtquelle kann zum Beispiel in Form einer UV-Booster-Platine in die Prüfkammer integriert sein. Bei Durchführung des Prüfverfahrens unter Verwendung der UV-Lichtquelle zur Vorionisierung der Prüfatmosphäre wird vor dem Anlegen der Prüfspannung in Form des Spannungspulses ein auf die zu prüfende elektrische, elektroisolierte Komponente und/oder die Feldelektrode gerichteter UV-Lichtimpuls zur Vorionisierung der Prüfkammeratmosphäre ausgelöst. Durch die Einwirkung ultravioletter Strahlung erfolgt eine Vorionisierung der Prüfkammeratmosphäre, also eine gezielte Erzeugung freier Ladungsträger (insbesondere Elektronen) im Gasvolumen, bevor der eigentliche Hochspannungspuls angelegt wird. Dies senkt die zur Zündung eines Lichtbogens erforderliche Durchschlagspannung und verbessert die Reproduzierbarkeit der Entladungsbildung. Die Vorionisierung unterstützt damit die Entstehung eines Lichtbogens an vorhandenen Isolationsdefekten, insbesondere bei schwach ausgeprägten Fehlstellen oder bei elektrisch ungünstigen Bedingungen, etwa wenn nur eine geringe Feldstärke am Fehlerort vorliegt. Die UV-Vorionisierung ist eine alternative oder ergänzende Maßnahme zur elektrischen Vorbelastung mittels eines Vorpulses. Sie ermöglicht eine saubere Trennung zwischen dem Ionisierungsprozess und dem eigentlichen Hochspannungsimpuls, wodurch sich eine klarere Auswertung der Reaktion auf den Prüfimpuls erzielen lässt. Die eingesetzte UV-Strahlung kann je nach Auslegung im Bereich von ca. 200 nm bis 400 nm liegen, wobei kurzwelligeres UV, zum Beispiel UV-C, bevorzugt wird, da es eine stärkere Ionisierungswirkung besitzt. Die Integration der UV-Lichtquelle als Teil der Prüfvorrichtung erlaubt eine feldfreie Vorkonditionierung der Atmosphäre und erhöht somit die Sensitivität des Prüfverfahrens, ohne dass die zu prüfende elektrische, elektroisolierte Komponente thermisch oder elektrisch belastet wird. Zusätzlich wird durch die Bestrahlung der Feldelektroden mit UV-Licht der sogenannte Photoeffekt ausgelöst, wodurch die zum Zündzeitpunkt notwendige Austrittsarbeit leichter überwunden werden kann. Auch dadurch lässt sich eine Entladung bereits mit einer geringeren Spannungsamplitude und/oder einer kürzeren Laufzeit der Prüfspannung erzielen.

Die Feldelektroden der Prüfvorrichtung können in verschiedenen Ausführungsformen realisiert sein, um sich an unterschiedliche Geometrien, Prüfstrategien und geometrische Ausbildungen der zu prüfenden elektrischen, elektroisolierten Komponenten anzupassen. Die Feldelektroden können u. a. stabförmig oder flächig ausgeführt sein. Stabförmige Feldelektroden erzeugen lokale Feldmaxima für punktuelle Prüfungen, während flächige Feldelektroden ein homogenes Feld über einen größeren Bereich aufbauen. Eine flächige Feldelektrode kann zum Beispiel mittels eines Leitgummikissens realisiert werden. In bestimmten Anwendungsfällen, insbesondere bei der Prüfung von Nutisolierungen vor dem Einbringen einer Wicklung, kann die Feldelektrode auch als drahtförmiges Element ausgebildet sein, das in die Nut eingebracht wird und temporär die Funktion einer Prüfwicklung übernimmt. Diese Feldelektrode kann axial oder seitlich in der Nut verlaufen und erzeugt ein definiertes Feld zur Prüfung der Nutisolation.

Grundsätzlich sind alle Feldelektroden so ausgestaltet, dass sie berührungslos zur zu prüfenden elektrischen, elektroisolierten Komponente angeordnet sind, um eine zerstörungsfreie Prüfung sicherzustellen. Für standardisierte Prüflinge, d. h. zu prüfende elektrische, elektroisolierte Komponenten, können die Feldelektroden auch fest in der Prüfkammer montiert sein. Alternativ können sie ortsvariabel oder beweglich ausgeführt sein, sodass sie mechanisch an unterschiedliche Geometrien der zu prüfenden elektrischen, elektroisolierten Komponenten angepasst werden können, etwa durch Verschiebung, Schwenkung oder Höheneinstellung. Ferner kann die Feldelektrode bei zylindrisch geformten, zu prüfenden elektrischen, elektroisolierten Komponenten auch koaxial um die Komponente herumgeführt sein, etwa in Form eines Hohlzylinders oder Rings, wodurch ein symmetrisches, radial gerichtetes Feld aufgebaut werden kann.

Diese Vielzahl an Ausgestaltungen erlaubt eine anwendungsspezifische Anpassung der Elektrodentechnologie zur effizienten, reproduzierbaren und empfindlichen Prüfung unterschiedlichster elektrischer, elektroisolierter Komponenten.

Die Prüfvorrichtung umfasst vorzugsweise mehrere der Feldelektroden. In einer bevorzugten Ausgestaltung sind die Feldelektroden hierbei segmentartig innerhalb der Prüfkammer so angeordnet, dass sie bestimmte Bereiche der zu prüfenden elektrischen, elektroisolierten Komponente gezielt adressieren. Diese Segmente sind über eine Relaismatrix einzeln zuschaltbar, sodass eine zonenweise oder sequentielle Prüfung ermöglicht wird.

Die segmentartige Anordnung der Feldelektroden innerhalb der Prüfkammer erlaubt eine gezielte Anpassung des elektrischen Feldes an unterschiedliche Geometrien der zu prüfenden elektrischen, elektroisolierten Komponenten. Die einzelnen Feldelektroden bilden definierte Teilflächen, die jeweils auf bestimmte Abschnitte der zu prüfenden elektrischen, elektroisolierten Komponente ausgerichtet sind. Durch die Ansteuerung der Feldelektroden über die Relaismatrix kann jede Feldelektrode separat aktiviert oder deaktiviert werden, sodass eine sequentielle oder selektive Beaufschlagung einzelner Prüfzonen möglich ist. Dies ist insbesondere für die Prüfung länglicher oder segmentierter Wicklungsstrukturen vorteilhaft, wie sie u. a. bei Hairpin-Wicklungen oder in Nutbereichen von Statoren vorkommen.

Durch die einzeln zuschaltbaren Feldelektroden wird die Positionsauflösung der Fehlererkennung unterstützt. Wird während eines Spannungspulses ein Lichtbogenereignis detektiert, so lässt sich anhand der aktiven Feldelektrode und ihrer räumlichen Position auf die mutmaßliche Lage des Isolationsfehlers schließen. Dies verbessert die Nachverfolgbarkeit im Serienprozess und ermöglicht gegebenenfalls eine gezielte Nacharbeit oder Analyse.

Darüber hinaus erlaubt die modulare Anordnung der Feldelektroden die Anpassung der Prüfvorrichtung an unterschiedliche Bauteilgeometrien, ohne mechanische Änderungen vornehmen zu müssen. Die Relaismatrix fungiert dabei als Schaltelement, mit dem die Spannungsversorgung für jede Feldelektrode individuell gesteuert wird. Dadurch können Prüfreihen automatisiert ablaufen, in denen mehrere zu prüfende elektrische, elektroisolierte Komponenten einer Baugruppe nacheinander mit Prüfspannung beaufschlagt und ausgewertet werden. Diese Architektur steigert die Prüfgeschwindigkeit und ermöglicht eine detaillierte, abschnittsweise Fehlerlokalisierung innerhalb eines komplexen Wicklungssystems.

Die Kombination aus segmentartiger Anordnung und elektrischer Einzelschaltung der Feldelektroden erweitert somit den Funktionsumfang der Prüfvorrichtung und macht sie besonders geeignet für den Einsatz in variantenreichen Fertigungsumgebungen mit unterschiedlichen Geometrien und Fehleranforderungen.

Gemäß einer weiteren vorteilhaften Ausgestaltung der Erfindung ist die Prüfvorrichtung zusätzlich mit einer Strommesseinrichtung zur Erfassung des elektrischen Stroms während des Spannungspulses ausgestattet. Die Strommessung erfolgt dabei synchron zur Erfassung des Istspannungsverlaufs und ergänzt diesen um eine weitere physikalische Messgröße, die zusätzliche Informationen über das Verhalten der zu prüfenden elektrischen, elektroisolierten Komponente während der elektrischen Belastung liefert.

Insbesondere kann der durch die Prüfvorrichtung erfasste Stromverlauf Hinweise auf das Zündverhalten eines Lichtbogens, dessen Dynamik sowie auf den Zeitpunkt und die Stärke des Stromdurchgangs liefern. Im Fehlerfall, insbesondere bei einem Isolationsdurchschlag, wird ein charakteristischer Stromanstieg beobachtet, der im Zusammenhang mit dem Spannungszusammenbruch ausgewertet werden kann. Die gleichzeitige Erfassung von Strom- und Spannungsverlauf ermöglicht somit eine präzisere Fehlererkennung sowie eine differenzierte Klassifizierung der Art des Isolationsversagens.

Die Auswertung des Stromsignals ist insbesondere bei sehr schnellen Entladungen vorteilhaft, da diese im reinen Spannungsverlauf unter Umständen nur schwach ausgeprägt oder überlagert auftreten. Durch die zusätzliche Strommessung kann in solchen Fällen dennoch eine zuverlässige Detektion und Signalauswertung erfolgen. Dies ist insbesondere bei Teilentladungen, kurzlebigen Lichtbogenereignissen oder weichen Durchschlägen von Bedeutung, bei denen der Spannungsabfall zwar gering, aber ein messbarer Stromimpuls vorhanden ist.

Die Messeinrichtung zur Stromerfassung kann dabei als shuntbasierte Messung, stromsensitiver Abgriff in der Hochspannungsleitung, als Mikrowellen-Antenne oder als stromwandlergestützte Sensorik ausgeführt sein, wobei eine geeignete Entkopplung vom Hochspannungsniveau vorgesehen ist. Die Integration der Strommessung in die Steuerungs- und Prüfeinheit erlaubt eine gemeinsame Bewertung von Strom- und Spannungsverlauf, wobei sowohl der maximale Stromwert, die Anstiegszeit als auch die Fläche unter dem Strom-Zeit-Verlauf zur Bewertung herangezogen werden können.

Besonders vorteilhaft ist diese Ausgestaltung in Kombination mit einer bildgebenden Kameraeinheit. Wird ein Lichtbogenereignis gleichzeitig über den Spannungsabfall, einen Stromimpuls und ein visuelles Signal registriert, so kann dies als sicherer Hinweis auf einen echten Isolationsfehler interpretiert werden. Umgekehrt kann auch bei einem detektierten Stromimpuls ohne Lichtbogen zwischen unkritischen Überschlägen und relevanten Fehlern unterschieden werden. Damit erhöht die zusätzliche Strommessung nicht nur die Prüfsicherheit, sondern verbessert auch die Fehlerklassifizierung und reduziert das Risiko von Fehlinterpretationen oder Pseudofehlern.

Zusammenfassend stellt die ergänzende Strommessung eine Erweiterung der Prüfvorrichtung dar, durch die die elektrische Reaktion auf die Prüfspannung detaillierter und robuster ausgewertet werden kann. Dies ist besonders in industriellen Umgebungen mit hohen Anforderungen an die Prüfsicherheit, Dokumentation und Nachverfolgbarkeit von Vorteil.

Gemäß einer weiteren bevorzugten Ausgestaltung der Erfindung ist die Prüfvorrichtung so eingerichtet, dass bei der Detektion eines Lichtbogenereignisses während des Spannungspulses eine sofortige Abschaltung der Hochspannungseinheit erfolgt. Die Detektion eines solchen Ereignisses erfolgt über die Steuerungs- und Prüfeinheit durch kontinuierliche Überwachung des Istspannungsverlaufs während des angelegten Spannungspulses. Wird dabei eine charakteristische Abweichung vom vordefinierten Sollspannungsverlauf festgestellt - etwa ein plötzlicher Spannungsabfall oder eine überdurchschnittliche Spannungseinbruchrate - erkennt die Steuerung dies als Hinweis auf ein Lichtbogenereignis und löst eine Abschaltfunktion aus.

Die Abschaltung erfolgt automatisiert und innerhalb kürzester Zeit nach der Detektion, typischerweise im Bereich weniger Mikrosekunden. Ziel dieser Maßnahme ist es, die Einwirkdauer des Lichtbogens auf die Isolationsstelle so gering wie möglich zu halten und dadurch Sekundärschäden oder thermische Belastung der zu prüfenden elektrischen, elektroisolierten Komponente zu vermeiden. Durch die sofortige Abschaltung wird eine minimale Energieeinbringung in den Fehlerbereich sichergestellt, was insbesondere bei der Prüfung empfindlicher oder noch weiterzuverarbeitender Bauteile entscheidend ist.

Die Abschaltlogik kann dabei sowohl auf der Auswertung des Spannungsverlaufs basieren als auch - bei entsprechend ausgestatteter Vorrichtung - zusätzliche Detektionssignale wie Stromimpulse oder optische Signale aus der Kameraeinheit berücksichtigen. In einer besonders vorteilhaften Ausführung erfolgt die Abschaltung nicht nur auf Basis eines Grenzwerts, sondern anhand einer dynamischen Verhaltensanalyse, etwa über die Steilheit des Spannungsabfalls (dU/dt) oder in Kombination mit einer Echtzeitkorrelation zu erkannten Lichtblitzen im Bildsignal.

Darüber hinaus ermöglicht die sofortige Abschaltung die gezielte Signalisierung eines Prüfabbruchs, sodass keine weitere Impulsbelastung auf das Bauteil erfolgt und die Prüfung automatisch gestoppt oder übersprungen wird. Dies erlaubt eine besonders materialsparende und bauteilschonende Prüfstrategie, wie sie in der Serienfertigung, insbesondere bei teuren oder sich in der Endmontage befindlichen Einheiten, erforderlich ist.

Zusätzlich kann die Abschaltfunktion mit einer Fehlerprotokollierung gekoppelt sein, sodass Zeitpunkt, Position (zum Beispiel über die Feldelektrode oder die Kameraeinheit) und Art des detektierten Ereignisses dokumentiert werden. Dies schafft nicht nur Transparenz im Fertigungsprozess, sondern erhöht auch die Rückverfolgbarkeit und Qualitätssicherung.

Insgesamt stellt die sofortige Abschaltung bei einem Lichtbogenereignis eine sicherheitstechnisch und prozesstechnisch besonders vorteilhafte Erweiterung der Prüfvorrichtung dar, da sie zur Schonung der zu prüfenden elektrischen, elektroisolierten Komponente, zur Vermeidung von Folgefehlern und zur präzisen Fehlererkennung beiträgt.

Es kann ferner vorgesehen sein, dass das Erfassen des Istspannungsverlaufs durch Abgreifen eines Spannungssignals an der Hochspannungseinheit erfolgt. D. h., der während des Prüfprozesses entstehende Istspannungsverlauf wird nicht direkt an der zu prüfenden elektrischen, elektroisolierten Komponente, sondern an der Hochspannungseinheit selbst abgenommen. Dabei wird ein Spannungssignal erfasst, das repräsentativ für die tatsächliche Spannungsbeanspruchung der zu prüfenden elektrischen, elektroisolierten Komponente ist. Die Hochspannungseinheit ist entsprechend so ausgestaltet, dass sie über geeignete Messeinrichtungen oder Ausgänge verfügt, an denen das Spannungssignal als Echtzeitsignal abgegriffen und an die Steuerungs- und Prüfeinheit weitergeleitet werden kann.

Durch das Abgreifen an der Hochspannungseinheit wird eine elektrisch entkoppelte, aber präzise Erfassung des Spannungssignals ermöglicht, das die dynamischen Veränderungen während des Spannungspulses - insbesondere Spannungseinbrüche infolge von Lichtbogenereignissen - eindeutig abbildet. Die elektrische Signalleitung kann dabei in sicherer Distanz zur zu prüfenden elektrischen, elektroisolierten Komponente geführt werden, was die Störsicherheit und elektrische Sicherheit des Gesamtsystems erhöht.

Zudem erlaubt diese Ausgestaltung eine besonders schnelle Signalauswertung, da keine zusätzlichen Sensoren an der elektrischen, elektroisolierten Komponente angebracht oder kalibriert werden müssen. Die Auswertung des abgegriffenen Signals erfolgt innerhalb der Steuerungs- und Prüfeinheit, die den Istspannungsverlauf mit dem hinterlegten Sollspannungsverlauf vergleicht, um Abweichungen durch Lichtbogenereignisse in Echtzeit zu erkennen. Die Struktur des abgegriffenen Signals - etwa Signalverlauf, Flankensteilheit, Einbruchdauer oder Integralwerte - kann dabei zur Erkennung und Bewertung unterschiedlicher Fehlerarten herangezogen werden.

Die Möglichkeit, das Spannungssignal unmittelbar an der Hochspannungseinheit abzugreifen, stellt somit eine einfach umsetzbare, störungsarme und verlässliche Maßnahme dar, um den elektrischen Prüfverlauf exakt zu dokumentieren und Isolationsfehler sicher zu detektieren. Darüber hinaus kann dieses Signal auch zur Ansteuerung von Folgefunktionen - wie zum Beispiel der sofortigen Abschaltung der Hochspannung im Fall eines detektierten Lichtbogens - genutzt werden, wodurch sich zusätzliche Sicherheits- und Schutzmechanismen realisieren lassen.

In einer bevorzugten Ausführung handelt es sich bei der Kameraeinheit um eine Hochgeschwindigkeitskamera, die in der Lage ist, auch sehr kurzlebige Lichtemissionen - wie sie beim Auftreten eines Lichtbogens typischerweise auftreten - mit hoher zeitlicher Auflösung zu erfassen. Die Bildaufnahme erfolgt synchron zum Spannungspuls, sodass eine präzise Korrelation zwischen elektrischer Anregung und optischem Ereignis möglich ist. Die hohe Bildfrequenz ermöglicht zudem eine zeitliche Rekonstruktion des Entladungsverlaufs, was insbesondere zur Charakterisierung der Dynamik des Isolationsfehlers genutzt werden kann.

Alternativ oder zusätzlich kann die Kameraeinheit als CMOS- oder CCD-basierte Industriekamera mit hoher Lichtempfindlichkeit ausgeführt sein, die auf die schnelle Erkennung von Helligkeitsspitzen im sichtbaren Spektrum ausgelegt ist. Diese Variante ist besonders robust und eignet sich für den Einsatz in Industrieumgebungen.

Zudem besteht die Möglichkeit, die Kameraeinheit mit einer spektralen Filterung auszustatten. Dies kann entweder über optische Bandpassfilter oder durch digitale Nachbearbeitung erfolgen. Dadurch lässt sich die Empfindlichkeit der Kameraeinheit gezielt auf das typische Spektrum eines Lichtbogens im jeweiligen Prozessgas (zum Beispiel Argon oder Helium) abstimmen, wodurch die Kontrastschärfe und Detektionssicherheit erhöht werden.

Weiterhin kann die Kameraeinheit als monochrome oder farbige Ausführung vorliegen. Eine monochrome Kamera bietet in der Regel eine höhere Lichtempfindlichkeit und wird bevorzugt eingesetzt, wenn die reine Intensität der Lichtemission detektiert werden soll. Farbkameras ermöglichen hingegen die spektrale Unterscheidung verschiedener Entladungsphänomene, was für eine differenzierte Fehleranalyse von Vorteil sein kann.

Für den Fall sehr kleiner oder abgeschirmter elektrischer, elektroisolierter Komponenten kann auch eine faseroptisch gekoppelte Mikrokamera vorgesehen sein, die über eine Lichtleiteranordnung das Bildsignal aus der Prüfkammer herausführt. Diese Variante ist besonders platzsparend und eignet sich für beengte Einbausituationen oder wenn die Kameraeinheit außerhalb der Prüfkammer positioniert werden soll.

Gemäß einer weiteren vorteilhaften Ausgestaltung der Erfindung umfasst die Prüfvorrichtung mehrere der Kameraeinheiten, die jeweils innerhalb oder außerhalb der Prüfkammer angeordnet sein können und zur visuellen Erfassung und Lokalisierung von Lichtbogenereignissen dienen. Durch den Einsatz mehrerer, vorzugsweise fest positionierter Kameraeinheiten wird eine mehrdimensionale, räumlich aufgelöste Beobachtung der zu prüfenden elektrischen, elektroisolierten Komponente ermöglicht.

Die einzelnen Kameraeinheiten sind hier so ausgerichtet, dass sie unterschiedliche Blickwinkel auf die Prüfumgebung und insbesondere auf jene Bereiche der elektrischen, elektroisolierten Komponente abdecken, in denen ein Auftreten von Isolationsfehlern zu erwarten ist. Dies betrifft insbesondere komplexe Bauteilgeometrien wie Hairpin-Wicklungen, Einzelzahnmodule oder segmentierte Statorstrukturen, bei denen sich ein Lichtbogenereignis auch seitlich, rückseitig oder verdeckt im Inneren der Komponente ausbilden kann.

Durch die räumlich verteilte Anordnung der Kameraeinheiten lassen sich optische Totzonen vermeiden und die Wahrscheinlichkeit erhöhen, dass ein Lichtbogenereignis bei seinem Auftreten sicher erfasst wird. Darüber hinaus können die Bildsignale mehrerer Kameraeinheiten in der Steuerungs- und Prüfeinheit miteinander korreliert werden, um die Position des Lichtbogenereignisses dreidimensional zu bestimmen. Dies erlaubt eine präzise Lokalisierung des Isolationsfehlers auf der Oberfläche oder innerhalb der Struktur der elektrischen, elektroisolierten Komponente.

Durch die Mehrkamera-Konfiguration können auch Bewegungsunschärfen reduziert werden, etwa bei sehr kurzen Lichtbogenimpulsen. Die parallele Aufzeichnung mehrerer Perspektiven ermöglicht in solchen Fällen eine robustere Erkennung, selbst wenn in einer der Kameraeinheiten der Lichtblitz nur schwach oder teilweise abgebildet wird.

Optional können die Kameraeinheiten mit unterschiedlichen spektralen Empfindlichkeiten ausgestattet sein, um neben sichtbarem Licht auch UV- oder Nahinfrarotstrahlung zu erfassen. Dadurch lassen sich zeitlich und spektral differenzierte Entladungsphänomene erkennen, die mit dem bloßen Auge oder einer Standardkamera nicht sichtbar wären.

Zur Verbesserung der kameragestützten Beobachtung kann die Prüfvorrichtung zudem eine in die Prüfkammer integrierte Beleuchtungseinheit aufweisen.

Gemäß einem weiteren Aspekt des Prüfverfahrens kann eine adaptive Reaktion auf den erfassten Istspannungsverlauf implementiert sein. Wenn zum Beispiel während eines Spannungspulses keine Entladung festgestellt wird, kann automatisch ein weiterer Spannungspuls mit leicht veränderter Pulsdauer oder Amplitude ausgelöst werden, um eine grenzwertige Isolationsschwäche gezielter aufzudecken.

Vorzugsweise umfasst die Prüfvorrichtung ferner eine Speichereinheit zur Protokollierung der Prüfergebnisse. Hierin können alle mittels der Steuerungs- und Prüfeinheit erfassten Ist- und Sollspannungsverläufe, erkannte Lichtbogenereignisse, Stromdaten und die Bilddaten der Kameraeinheit dokumentiert werden. Diese Funktion verbessert die Rückverfolgbarkeit und kann für Qualitätssicherungsprozesse genutzt werden - insbesondere in der Serienfertigung oder bei Sicherheitsbauteilen.

Eine weitere vorteilhafte Ausgestaltung des Prüfverfahrens ergibt sich schließlich aus der kombinierten Bewertung elektrischer und optischer Detektionsdaten. Dabei wird ein Lichtbogenereignis nur dann als Isolationsfehler gewertet, wenn sowohl eine charakteristische Abweichung im Istspannungsverlauf als auch ein optisch erfassbares Lichtemissionsereignis vorliegt. Diese Doppeldetektion erhöht die Zuverlässigkeit und reduziert die Fehlalarmrate.

Die Erfindung ist nachfolgend anhand von Ausführungsbeispielen und mit Bezug auf die Zeichnungen näher erläutert, wobei gleiche oder ähnliche Merkmale mit gleichen Bezugszeichen versehen sind; dazu zeigen:
- Fig. 1:: eine Ausführung der Prüfvorrichtung zur Prüfung von Wicklungen in schematischer Schnittdarstellung,
- Fig. 2:: Komponenten einer Ausführung der Prüfvorrichtung zur Prüfung der Wicklungen eines Stators in perspektivischer Ansicht,
- Fig. 3:: die Ausführung nach Fig. 2 in Seitenansicht,
- Fig. 4:: die Ausführung nach Fig. 2 in Arbeitsstellung in Seitenansicht, und
- Fig. 5:: die Prüfkammer einer Ausführung der Prüfvorrichtung in perspektivischer Ansicht.

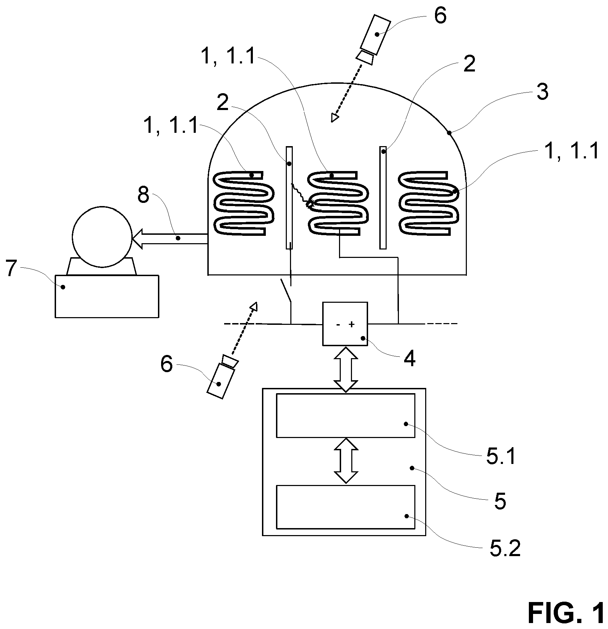

Die Prüfvorrichtung gemäß Fig. 1 umfasst die Prüfkammer 3, in der die zu prüfenden elektrischen, elektroisolierten Komponenten 1, hier Wicklungsdrähte 1.1, zur Prüfung eingebracht sind. Die Feldelektroden 2 sind zwischen den Wicklungsdrähten 1.1 positioniert. Mittels der Unterdruckerzeugungseinheit 7, hier eine Vakuumpumpe, wird die Prüfkammer 3 über die Evakuierungsleitung 8 evakuiert, um die Prüfkammeratmosphäre zur Prüfung einzustellen. Mittels der Hochspannungseinheit 4 wird die Prüfspannung zwischen einer der Feldelektroden 2 und einer der elektrischen, elektroisolierten Komponenten 1, d. h. einem der Wicklungsdrähte 1.1, angelegt. Die Hochspannungseinheit 4 ist mit der Steuerungs- und Prüfeinheit 5 verbunden, die eine Messtechnikeinheit 5.1 und einen Prüfrechner 5.2 umfasst. Mittels der Messtechnikeinheit 5.1 wird der Istspannungsverlauf der Prüfspannung während des Spannungspulses gemessen. Über den Prüfrechner 5.2 wird der gemessene Istspannungsverlauf ausgewertet, d. h. mit den vorgegebenen Sollspannungsverläufen verglichen, und die Prüfvorrichtung gesteuert. Bei Erkennen eines Lichtbogenereignisses wird die Hochspannungseinheit 4 abgeschaltet und der Prüfvorgang unterbrochen. Mittels der beiden Kameraeinheiten 6 wird das Innere der Prüfkammer 3, die aus transparentem Wandmaterial aufgebaut ist, aus verschiedenen Blickwinkeln beobachtet, um die Lichtbogenereignisse zu erfassen. Mit der im Beispiel gezeigten Prüfvorrichtung zur Drahtisolationsprüfung wird das Prüfverfahren so ausgeführt, dass die einzelnen Feldelektroden 2 nacheinander geschaltet werden.

Das Prüfverfahren wird nachfolgend anhand eines Fehlerfalls und eines Nicht-Fehlerfalls erläutert:
Ist im Bereich der Isolationsschicht der elektrischen, elektroisolierten Komponente 1 ein Isolationsfehler vorhanden - etwa ein Riss, eine punktuelle Durchschwächung oder eine Fehlstelle -, so kommt es im Moment des Spannungspulses zur Zündung eines Lichtbogens. Der Lichtbogen bildet sich zwischen der Feldelektrode 2 und der elektrisch leitfähigen Basisstruktur der elektrischen, elektroisolierten Komponente 1 im Bereich der fehlerhaften Isolationsstelle aus. Das Lichtbogenereignis führt unmittelbar zu einem charakteristischen Spannungszusammenbruch, der sich im Istspannungsverlauf abbildet. Die Steuerungs- und Prüfeinheit 5 vergleicht den Istspannungsverlauf mit einem gespeicherten Sollspannungsverlauf. Bei einer signifikanten Abweichung - insbesondere bei schnellem Spannungseinbruch oder abweichender Pulslänge - wird ein Fehler detektiert. Zusätzlich wird das Lichtbogenereignis von einer oder mehreren der Kameraeinheiten 6 visuell erfasst. Der entstehende Lichtblitz wird durch die jeweilige Kameraeinheit 6 aufgenommen und in Echtzeit ausgewertet. Die Position des Lichtbogens lässt sich durch die Bilddaten exakt lokalisieren. Zur Vermeidung von Folgeschäden an der Komponente wird die Hochspannungseinheit 4 abgeschaltet, sobald das Lichtbogenereignis erkannt wird.

Ist die Isolationsschicht der elektrischen, elektroisolierten Komponente 1 hingegen intakt, so führt der angelegte Spannungspuls zu keiner Entladung. Das elektrische Feld liegt zwar zwischen der Feldelektrode 2 und der leitfähigen Basisstruktur der elektrischen, elektroisolierten Komponente 1 an, jedoch verbleibt die Prüfspannung während des gesamten Spannungspulses innerhalb des spezifizierten Sollspannungsverlaufs. Es kommt weder zu einem Spannungszusammenbruch noch zu einem messbaren Stromdurchschlag. Die Kameraeinheit 6 erfasst kein Lichtbogenereignis, da keine Entladung vorliegt. Die Bilddaten zeigen einen dunklen, unveränderten Bereich, was durch die Steuerungs- und Prüfeinheit 5 als "kein Fehler" gewertet wird. Nach Abschluss des Spannungspulses wird die elektrischen, elektroisolierte Komponente 1 als fehlerfrei klassifiziert.

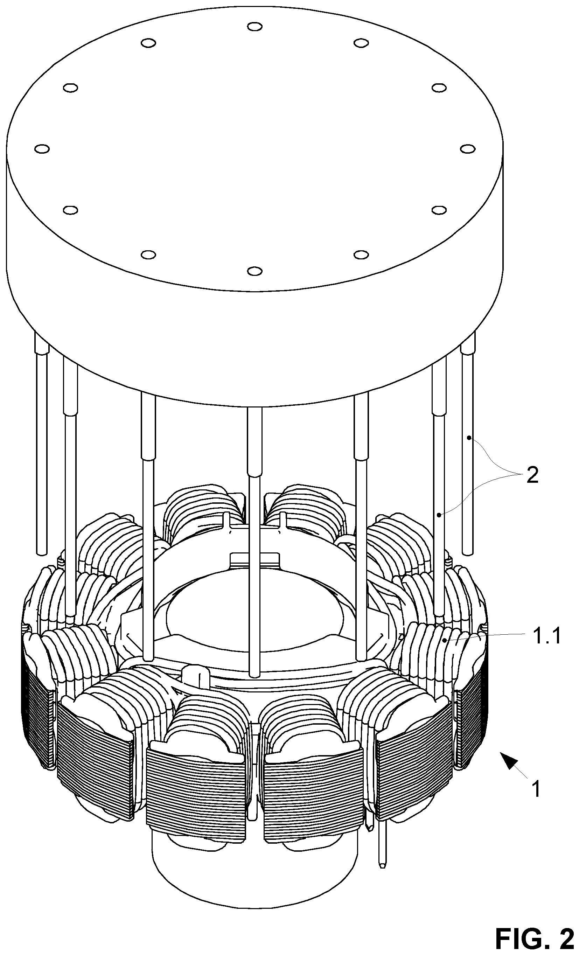

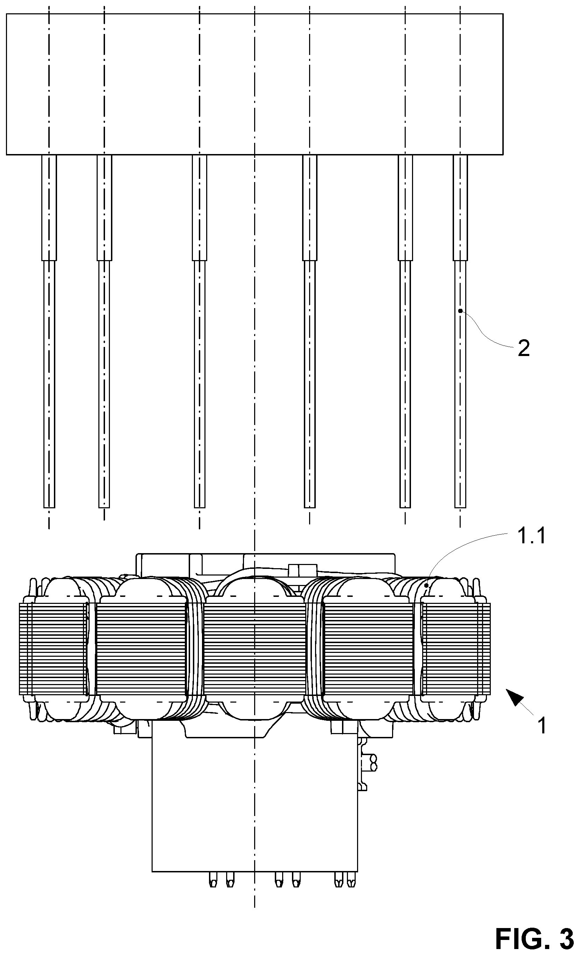

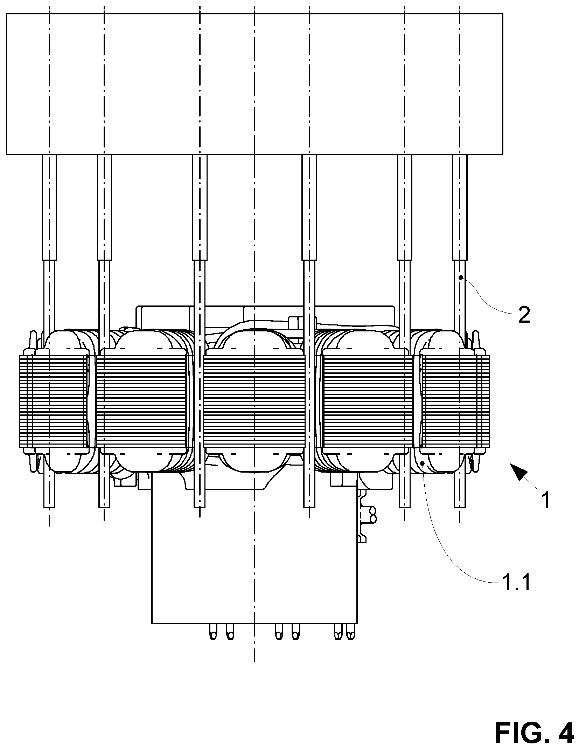

Die Fig. 2, Fig. 3 und Fig. 4 zeigen einen Stator einer elektrischen Maschine mit 12 Spulen bzw. Wicklungen, die bzw. deren Wicklungsdrähte 1.1 die zu prüfenden elektrischen, elektroisolierten Komponenten 1 bilden. Berührungslos zur jeweiligen elektrischen, elektroisolierten Komponente 1, d. h. zu der jeweiligen Wicklung, sind die 12 Feldelektroden 2 angeordnet. Diese stabförmigen Feldelektroden 2 werden zur Durchführung des Prüfverfahrens zwischen den Wicklungen positioniert. Die Feldelektroden 2 sind zum Beispiel Aluminium-Stabelektroden. Die Fig. 2 und die Fig. 3 zeigen die Grund- bzw. Ausgangsstellung vor der Prüfung; Fig. 4 veranschaulicht die Arbeitsstellung während der Prüfung.

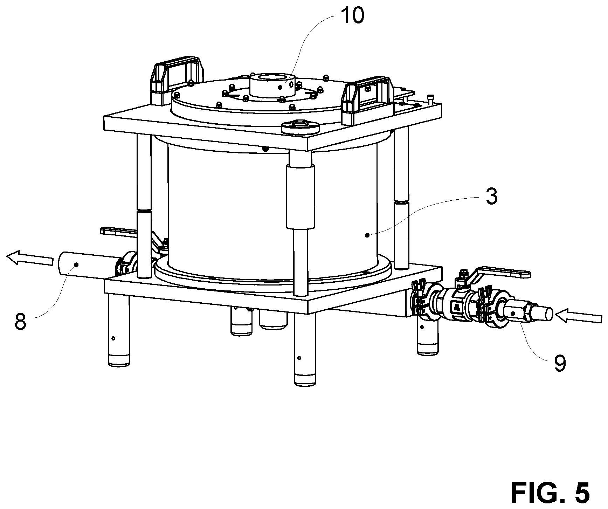

Die Einheit befindet sich bei Durchführung des Prüfverfahrens in der in Fig. 5 dargestellten Prüfkammer 3, die über die Evakuierungsleitung 8 evakuierbar ist und in die über die Prozessgasleitung 9 gezielt Prozessgas zuführbar ist, um die gewünschte Prüfkammeratmosphäre in der Prüfkammer 3 einzustellen. Die (nicht dargestellte) Kameraeinheit 6 ist an einem Aufnehmer 10 im Deckelbereich der Prüfkammer 3 anbringbar.

### Bezugszeichenliste

- 1: elektrische, elektroisolierte Komponente
- 1.1: Wicklungsdraht
- 2: Feldelektrode
- 3: Prüfkammer
- 4: Hochspannungseinheit
- 5: Steuerungs- und Prüfeinheit
- 5.1: Messtechnikeinheit
- 5.2: Prüfrechner
- 6: Kameraeinheit
- 7: Unterdruckerzeugungseinheit
- 8: Evakuierungsleitung
- 9: Prozessgasleitung
- 10: Aufnehmer für Kameraeinheit

## Patentansprüche

1. Prüfvorrichtung zur Detektion von Isolationsfehlern an einer elektrischen, elektroisolierten Komponente (1) einer ein Wicklungssystem beinhaltenden Baugruppe einer elektrischen Maschine, wobei die zu prüfende elektroisolierte Komponente (1) eine Isolationsschicht auf einer elektrisch leitfähigen Basisstruktur umfasst,
wobei die Prüfvorrichtung aufweist:
- eine Prüfkammer (3) zur Aufnahme der zu prüfenden elektrischen, elektroisolierten Komponente (1), wobei die Prüfkammer (3) atmosphärisch abgedichtet ist und eine definierte Prüfkammeratmosphäre beinhaltet,
- mindestens eine Hochspannungseinheit (4) zur Erzeugung einer Prüfspannung in Form von Spannungspulsen einer Gleichspannung mit einer Amplitude im Bereich von 500 V und 3000 V, wobei die Spannungspulse jeweils einen definierten Sollspannungsverlauf aufweisen,
- mindestens eine im Inneren der Prüfkammer (3) berührungslos zu der zu prüfenden elektrischen, elektroisolierten Komponente (1) angeordnete Feldelektrode (2), wobei die elektrisch leitfähige Basisstruktur der zu prüfenden elektroisolierten Komponente (1) sowie die Feldelektrode (2) mit der Hochspannungseinheit (4) so verbunden sind, dass die Prüfspannung zwischen der elektrisch leitfähigen Basisstruktur der zu prüfenden elektrischen, elektroisolierten Komponente (1) und der Feldelektrode (2) anliegt,
- eine Steuerungs- und Prüfeinheit (5), die eingerichtet ist, das Anlegen der Prüfspannung zu steuern, den Istspannungsverlauf der Prüfspannung während des Spannungspulses zu erfassen und bei Spannungsdurchschlägen auftretende Lichtbogenereignisse anhand von Abweichungen zwischen dem Istspannungsverlauf und dem Sollspannungsverlauf zu erkennen und zu signalisieren, sowie
- mindestens eine Kameraeinheit (6) zur visuellen Lokalisierung der Lichtbogenereignisse.

2. Prüfvorrichtung nach Anspruch 1, **dadurch gekennzeichnet, dass** die Prüfvorrichtung ferner eine an die Prüfkammer (3) angeschlossene Unterdruckerzeugungseinheit (7) zur Evakuierung der Prüfkammer (3) und zur Erzeugung einer Prüfkammeratmosphäre mit einem Druck im Bereich von 1 mbar bis 10 mbar aufweist.

3. Prüfvorrichtung nach Anspruch 1 oder 2, **dadurch gekennzeichnet, dass** die Prüfvorrichtung ferner ein an die Prüfkammer (3) angeschlossenes Prozessgasmodul zur Einleitung eines die Prüfkammeratmosphäre bildenden Prozessgases in die Prüfkammer (3) umfasst.

4. Prüfvorrichtung nach einem der Ansprüche 1 bis 3, **dadurch gekennzeichnet, dass** die Prüfvorrichtung ferner eine in der Prüfkammer (3) angeordnete UV-Lichtquelle zur Vorionisierung der Prüfatmosphäre aufweist.

5. Prüfvorrichtung nach einem der Ansprüche 1 bis 4, **dadurch gekennzeichnet, dass** diese mehrere der Feldelektroden (2) umfasst, wobei die Feldelektroden (2) segmentartig angeordnet und über eine Relaismatrix einzeln zuschaltbar sind.

6. Prüfverfahren zur Detektion von Isolationsfehlern an einer elektrischen, elektroisolierten Komponente (1) einer ein Wicklungssystem beinhaltenden Baugruppe einer elektrischen Maschine, wobei die zu prüfende elektrischen, elektroisolierte Komponente (1) eine Isolationsschicht auf einer elektrisch leitfähigen Basisstruktur umfasst,
**dadurch gekennzeichnet, dass** das Prüfverfahren mittels einer Prüfvorrichtung nach einem der Ansprüche 1 bis 5 durchgeführt wird, wobei das Prüfverfahren die folgenden Schritte umfasst:
a) Einbringen der zu prüfenden elektrischen, elektroisolierten Komponente (1) in die Prüfkammer (3),
b) Positionieren der mindestens einen Feldelektrode (2) in vorgegebenem Abstand zur zu prüfenden elektrischen, elektroisolierten Komponente (1),
c) Einstellen einer definierten Prüfkammeratmosphäre in der Prüfkammer (3),
d) Anlegen einer als Gleichspannung ausgeprägten Prüfspannung zwischen der elektrisch leitfähigen Basisstruktur der zu prüfenden elektrischen, elektroisolierten Komponente (1) und der Feldelektrode (2) in Form eines Spannungspulses mit einem definierten zeitlichen Sollspannungsverlauf, wobei der Spannungspuls eine Amplitude im Bereich von 500 V bis 2000 V und eine Pulsdauer im Bereich von 3 µs bis 15 µs aufweist,
e) Erfassen des zeitlichen Istspannungsverlaufs der Prüfspannung während des Spannungspulses,
f) Vergleichen des Sollspannungsverlaufs und des Istspannungsverlaufs der Prüfspannung, Erkennen eines Lichtbogenereignisses anhand von Abweichungen des Istspannungsverlaufs vom Sollspannungsverlauf und Auslösen eines Signals bei Erkennung eines Lichtbogenereignisses,
g) Aufzeichnen von einem oder mehreren Bildern der zu prüfenden elektrischen, elektroisolierten Komponente (1) während des Spannungspulses mittels der Kameraeinheit (6) zur Erfassung und Lokalisierung des Lichtbogenereignisses.

7. Prüfverfahren nach Anspruch 6, **dadurch gekennzeichnet, dass** die Prüfkammeratmosphäre einen Druck im Bereich von 1 mbar bis 10 mbar aufweist.

8. Prüfverfahren nach Anspruch 6 oder 7, **dadurch gekennzeichnet, dass** die Prüfkammeratmosphäre überwiegend aus einem Edelgas besteht.

9. Prüfverfahren nach einem der Ansprüche 6 bis 8, **dadurch gekennzeichnet, dass** vor dem Anlegen einer Prüfspannung in Form des Spannungspulses ein Vorpuls zur Vorionisierung der Prüfkammeratmosphäre vorgeschaltet wird.

10. Prüfverfahren nach einem der Ansprüche 6 bis 9, **dadurch gekennzeichnet, dass** vor dem Anlegen einer Prüfspannung in Form des Spannungspulses ein auf die zu prüfende elektrische, elektroisolierte Komponente (1) und/oder die Feldelektrode (2) gerichteter UV-Lichtimpuls zur Vorionisierung der Prüfkammeratmosphäre ausgelöst wird.
